# EUROPÄISCHE PATENTANMELDUNG

(11) **EP 1 152 459 A2**
(43) Veröffentlichungstag der Anmeldung: **07.11.2001**
(21) Anmeldenummer: 01110870.1
(22) Anmeldetag: 04.05.2001
(51) Int. Cl.: H01L 21/265, H01L 21/285, H01L 21/768

(54) **Verfahren zum Herstellen einer Barriereschicht in einem elektronischen Bauelement**

(30) Priorität: 05.05.2000 DE 10021871
(71) Anmelder: Infineon Technologies AG, 81669 München (DE)
(72) Erfinder: Cappellani, Annalisa, 01099 Dresden (DE); Willer, Josef, Dr., 85521 Riemerling (DE); Schumann, Dirk, Dr., 01097 Dresden (DE)
(74) Vertreter: Viering, Jentschura & Partner

(57) **Zusammenfassung**

Eine Barriereschicht wird auf einer Substratschicht gebildet, indem Implantierungsatome in das Substratmaterial der Substratschicht implantiert werden. Auf das Substratmaterial wird eine Metallschicht aufgebracht und das Substratmaterial, die Implantierungsatome und die Metallschicht werden zumindest teilweise miteinander in Reaktion gebracht derart, dass die Barriereschicht gebildet wird.

## Beschreibung

Die Erfindung betrifft ein Verfahren zum Herstellen einer Barriereschicht in einem elektronischen Bauelement und ein Verfahren zum Herstellen eines elektronischen Bauelements mit einer Barriereschicht.

Ein solches Verfahren ist aus [1] bekannt.

Bei diesem bekannten Verfahren wird eine Barriereschicht in einem elektronischen Bauelement, die üblicherweise als Barriereschicht zwischen einer Metallschicht und einer Substratschicht verwendet wird, beispielsweise im Rahmen einer Gate-Elektrode eines Feldeffekttransistors oder im Rahmen des Bildens eines elektrischen Kontakts zwischen isolierenden Schichten innerhalb eines elektronischen Bauelements eingesetzt.

Aus [1] ist es bekannt, auf eine Substratschicht aus Polysilizium eine Barriereschicht aus Wolfram-Nitrid WNₓ aufzutragen. Das Auftragen erfolgt mittels eines amorphen Sputterns der Wolfram-Nitrid-Schicht auf die Polysiliziumschicht.

Das sich somit ergebende Element wird einem Kurzzeittemper-Verfahren unterzogen bei einer Temperatur von ungefähr 1000 □C. Durch das Kurzzeittempern reagiert ein Teil der Wolfram-Nitrid-Schicht derart, dass sich eine sehr dünne Barriereschicht der Dicke von ungefähr 2 nm direkt an der Oberfläche der Polysiliziumschicht ablagert.

Die Barriereschicht wird gebildet aus einer Legierung aus Wolfram, Nitrid und Silizium, d.h. es bildet sich eine Schicht aus WₓN_{y}Si_{z}. Die Legierung aus WₓN_{y}Si_{z} dient als Barriereschicht gegen die sich über der Barriereschicht bildende Schicht aus Wolfram W und verhindert eine Silizidierung des Wolframs durch die Barriereschicht hindurch.

Diese bekannte Vorgehensweise weist einige Nachteile auf.

Insbesondere ist es für eine Wolfram-Nitrid-Schicht aufwendig, diese mittels eines Sputter-Verfahrens auf die Polysiliziumschicht aufzutragen.

Ferner ist ein Nachteil bei dieser Vorgehensweise darin zu sehen, dass aufgrund des Sputterns eine Partikelbildung auftritt, was insbesondere bei immer weiter reduzierten Dimensionen von elektronischen Bauelementen nicht wünschenswert ist.

Weiterhin ist aus [2] eine Silizidierung unter Verwendung von Kobalt als Metall bekannt, womit eine Kobalt-Silizidschicht auf einer Polysiliziumschicht gebildet wird. Auf diese Weise wird die elektrische Leitfähigkeit der Polysiliziumschicht verringert, da das Kobaltsilizid eine verglichen mit dem Polysilizium erhöhte elektrische Leitfähigkeit aufweist.

Weitere Verfahren der Silizidierung sind in [3], [4], und [5] beschrieben.

Somit liegt der Erfindung das Problem zugrunde, ein Verfahren zum Herstellen einer Barriereschicht in einem elektronischen Bauelement bzw. ein Verfahren zum Herstellen des elektronischen Bauelements anzugeben, welches einfacher, kostengünstiger und schneller durchführbar ist als das aus [1] bekannten Verfahren.

Das Problem wird durch das Verfahren zum Herstellen einer Barriereschicht in einem elektronischen Bauelement sowie durch das Verfahren zum Herstellen eines elektronischen Bauelements mit einer Barriereschicht mit den Merkmalen gemäß den unabhängigen Patentansprüchen gelöst.

Bei einem Verfahren zum Herstellen einer Barriereschicht in einem elektronischen Bauelement werden Implantierungsatome, die zum Bilden der Barriereschicht dienen, in ein Substratmaterial implantiert. Auf das Substratmaterial wird eine Metallschicht aufgebracht und das Substratmaterial, die Implantierungsatome und die Metallschicht werden zumindest teilweise miteinander in Reaktion gebracht derart, dass die Barriereschicht gebildet wird.

Als Substratmaterial kann beispielsweise Silizium, Gallium-Arsenid oder auch Germanium verwendet werden.

Als Implantierungsatome eignen sich beispielsweise Stickstoffatome oder Boratome.

Werden Boratome verwendet, so ist es beispielsweise möglich, eine p⁺ dotierte Gate-Elektrode eines Feldeffekttransistors zu erzeugen.

Das Substratmaterial, die Implantierungsatome sowie die Metallschicht können mittels Temperung, beispielsweise mittels einer Kurzzeittemperung bei einer Temperatur von ungefähr 1000 □C miteinander in Reaktion gebracht werden, so dass eine Legierung zwischen dem Substratmaterial, dem Implantierungsatom und der Metallschicht gebildet wird, die als Barriereschicht dient. Durch die Barriereschicht wird eine Silizidierung der Metallschicht durch die Barriereschicht hindurch verhindert. Anders ausgedrückt bedeutet dies, dass der Begriff "Barriereschicht" in diesem Zusammenhang zu verstehen ist als eine Schicht, mittels der eine Silizidierung einer über der Barriereschicht angeordneten Metallschicht verhindert wird.

Die Implantierung der Implantierungsatome kann auf unterschiedliche Weise erfolgen.

Es ist möglich, die Implantierungsatome direkt in das Substratmaterial zu implantieren.

Alternativ kann auf das Substratmaterial eine Metallschicht aufgebracht werden, und die Implantierung der Implantierungsatome kann durch die Metallschicht hindurch in einem Grenzbereich des Substratmaterials und der Metallschicht erfolgen.

Ferner ist es gemäß einer Weiterbildung der Erfindung vorgesehen, auf das Substratmaterial eine Oxidschicht, die als Streuoxidschicht dient, aufzubringen, beispielsweise mittels eines CVD-Verfahrens (**C**hemical **V**apour **D**eposition-Verfahren), eines Plasma-Enhanced CVD-Verfahrens (PECVD-Verfahren) oder eines PVD-Verfahrens. Alternativ kann anstelle des Streuoxids auch eine Nitridschicht, beispielsweise eine Schicht aus Siliziumnitrid auf dem Substratmaterial aufgebracht werden.

Die Implantierung kann durch das Streuoxid hindurch erfolgen, so dass sich ein Dotierungsprofil der Implantierungsatome in einem Grenzbereich der Substratschicht und der Streuoxidschicht ausbildet.

In diesem Fall wird die Streuoxidschicht nach erfolgtem Implantieren entfernt, beispielsweise mittels eines Nassätzverfahrens, eines Trockenätzverfahrens oder mittels eines **C**hemisch-**M**echanischen **P**olierverfahrens (CMP-Verfahren), und die Metallschicht wird auf die mit den Implantierungsatomen versehene Substratschicht aufgebracht.

Ferner ist darauf hinzuweisen, dass die Implantation sowohl bei einer schon strukturierten Schicht als auch bei einer unstrukturierten Schicht erfolgen kann, d.h. bei ganzflächiger Schicht über der Substratschicht, der Metallschicht oder der Streuoxidschicht.

Die Streuoxidschicht kann Siliziumoxid enthalten.

Ferner kann die Metallschicht zumindest eines der folgenden Metalle enthalten:
- Wolfram,
- Molybdän,
- Tantal,
- Rhenium,
- Titan,
- Zirkon,
- Hafnium,
- Niob, und/oder
- Ruthenium.

Ein elektronisches Bauelement, insbesondere ein Feldeffekttransistor wird derart gebildet, dass gemäß bekannten Verfahrensschritten das elektronische Bauelement hergestellt wird, wobei das Bilden der Barriereschicht in dem elektronischen Bauelement gemäß dem oben beschriebenen Verfahren gebildet wird.

Insbesondere kann ein MOS-Feldeffekttransistor hergestellt werden, wobei gemäß dem oben beschriebenen Verfahren eine Barriereschicht zwischen dem Kanalbereich des MOS-Feldeffekttransistors und der Metallschicht, die als Gate-Anschluss dient, hergestellt werden kann.

Die Metallschicht, die mittels der Barriereschicht chemisch von dem Substratmaterial "abgeschirmt" wird, kann auch als elektrischer Kontakt in einem elektronischen Bauelement verwendet werden.

Durch den einfachen Prozess des Implantierens von Implantierungsatomen wird gegenüber dem Stand der Technik nunmehr eine erhebliche Vereinfachung des Herstellungsprozesses einer Barriereschicht erreicht, da nunmehr keine aufwendigen Mechanismen zum Sputtern der Barriereschicht vorgesehen werden müssen. Auch wird die durch das Sputtern verursachte Partikelbildung vermieden.

Weiterhin ist mittels des Implantierens eine sehr genaue Einstellung des Implantierungsprofils, d.h. die Einstellung der Verteilung der Implantierungsatome in der Substratschicht und/oder in der Metallschicht auf einfache Weise möglich.

Ferner ist darauf hinzuweisen, dass das Aufbringen der Wolfram-Nitrid-Schicht WNₓ mittels eines CVD-Verfahrens zwar möglich ist, aber eine Titan-Nitrid-Schicht TiNₓ, oder Tantal-Nitrid TaNₓ, die ebenfalls zur Bildung von einer Barriereschicht grundsätzlich verwendet werden, nicht ohne weiteres mit einem Verfahren gemäß dem Stand der Technik unter Verwendung eines CVD-Verfahrens möglich ist.

Durch die Erfindung wird diese Problematik, dass verschiedene Metalle, die für die Metallschicht eingesetzt werden können, nicht mittels eines Sputter-Verfahrens oder auch eines CVD-Verfahrens auf das Substratmaterial aufgebracht werden können, umgangen.

Durch Verbinden des Implantierungsverfahrens und des Temperns zum Bilden der Barriereschicht wird ein ohnehin im Rahmen eines üblichen Herstellungsprozesses von Feldeffekttransistoren erforderlicher Temperschritt gleichzeitig ausgenutzt zur Bildung der Barriereschicht.

Durch die Erfindung ist somit insbesondere auch eine erhebliche Flexibilität im Rahmen des Herstellungsprozesses eines elektronischen Bauelements gewährleistet, da insbesondere das Implantieren an unterschiedlichen Verfahrensstufen und in unterschiedlichen Herstellungsverfahren sehr einfach und flexibel eingesetzt werden kann.

Ausführungsbeispiele der Erfindung sind in den Figuren dargestellt und werden im weiteren näher erläutert.

### Es zeigen

- Figuren 1a bis 1g: verschiedene Verfahrenszustände des Bauelements während des Herstellungsverfahrens gemäß einem ersten Ausführungsbeispiel;
- Figuren 2a bis 2e: verschiedene Verfahrenszustände des Bauelements während des Herstellungsverfahrens gemäß einem zweiten Ausführungsbeispiel;
- Figuren 3a bis 3c: Skizzen verschiedene Verfahrenszustände des Bauelements während des Herstellungsverfahrens gemäß einem dritten Ausführungsbeispiel.

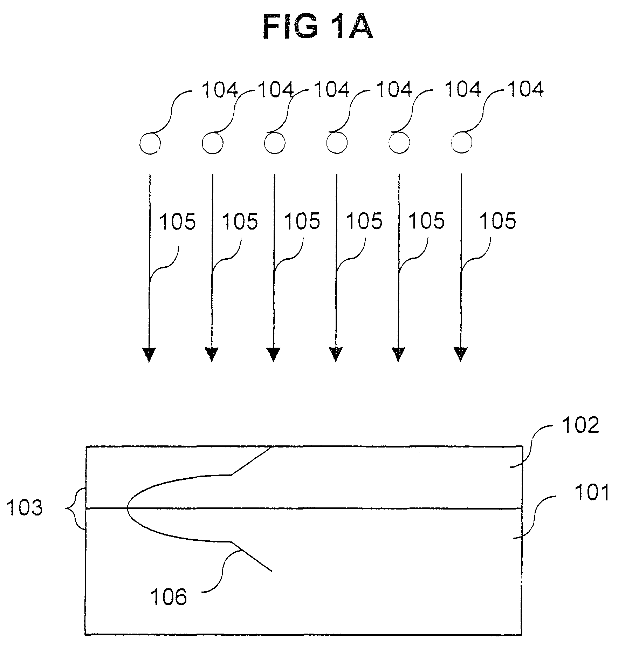

**Fig.1a** zeigt eine Substratschicht 101 aus Silizium oder Polysilizium, auf der mittels eines CVD-Verfahrens oder eines PECVD-Verfahrens eine Streuoxidschicht 102 aus Siliziumoxid abgeschieden wird.

Als Streuoxidschicht 102 kann beispielsweise ferner eine TEOS-Schicht der Dicke von ungefähr 65 nm verwendet werden.

In dem Grenzbereich 103 zwischen der Substratschicht 101 und der Streuoxidschicht 102 werden mittels eines Implantationsverfahrens Stickstoffatome 104 unter einer Implantationspannung von ungefähr 20 keV implantiert. Die Implantation der Stickstoffatome 104 ist in **Fig.1a** durch Pfeile 105 symbolisiert.

Um zu vermeiden, dass eine zu geringe Implantationsspannung zum Implantieren der Stickstoffatome 104 erforderlich ist, wird die Streuoxidschicht 102 verwendet. Alternativ kann anstelle der Streuoxidschicht eine Streunitridschicht aus Silizium-Nitrid vorgesehen sein.

Die Streuoxidschicht 102 weist eine Dicke von ungefähr 65 nm auf.

Die Dosis der implantierten Stickstoffatome ist so groß gewählt, dass beispielsweise eine Stickstoffkonzentration an der Oberfläche 108 der Substratschicht 101 von 5*10¹⁵ Atomen Stickstoff / cm² erreicht wird.

Nach der Implantation ergibt sich ein erstes Implantationsprofil 106, wie in **Fig.1a** dargestellt.

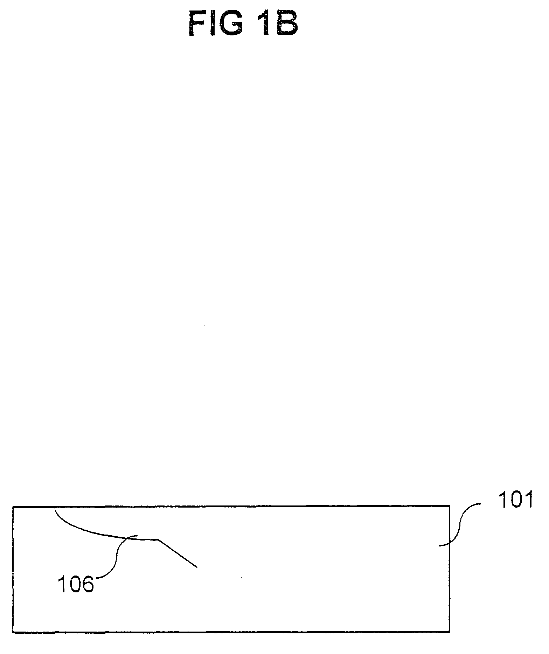

In einem weiteren Schritt (vgl. **Fig.1b**) wird die Streuoxidschicht 102 mittels eines Trockenätzverfahrens, eines Nassätzverfahrens oder mittels eines CMP-Verfahrens entfernt, so dass die mit den Stickstoffatomen 104 dotierte Substratschicht 101 erhalten bleibt.

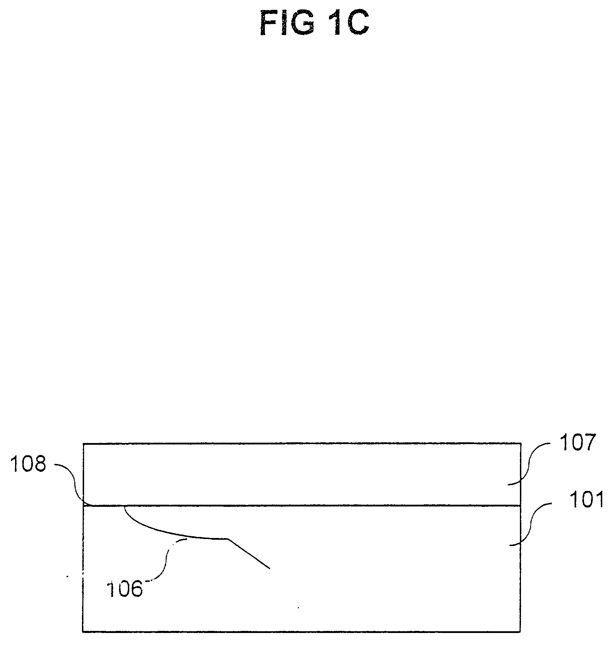

Wie in **Fig.1c** dargestellt ist, wird auf die Substratschicht 101 mit den implantierten Stickstoffatomen 104 eine Metallschicht 107 aufgebracht, gemäß dem Ausführungsbeispiel mittels eines CVD-Verfahrens.

Die Metallschicht 107 ist gemäß dem Ausführungsbeispiel aus Wolfram.

Bei dem Auftragen der Metallschicht 107 auf die Substratschicht 101 ist unter anderem auf den Verbindungsbereich zwischen der Metallschicht 107 und der Substratschicht 101 zu achten.

Insbesondere ist darauf zu achten, dass eine Diffusion der Metallatome der Metallschicht 107 in die Substratschicht 101 vermieden wird.

Ferner ist darauf zu achten, dass die Metallschicht 107 physikalisch gut an der Oberfläche 108 der Substratschicht 101 haftet. Es hat sich experimentell erwiesen, dass beispielsweise bei einer Wolfram-Schicht als Metallschicht 107, die mittels eines CVD-Verfahrens abgeschieden wird, eine gute Haftung auf einfache Weise dadurch erreicht wird, dass der Nukleationsschritt der Silizium-Bekeimung bei der CVD-Wolfram-Abscheidung weggelassen wird, d.h. anschaulich, dass der Nukleationsschritt der Silizium-Bekeimung übersprungen wird.

In diesem Fall kann das Abscheiden erfolgen, indem lediglich Wolfram-Fluorid WF₆ und Wasserstoff H₂ als Prozessgase verwendet werden.

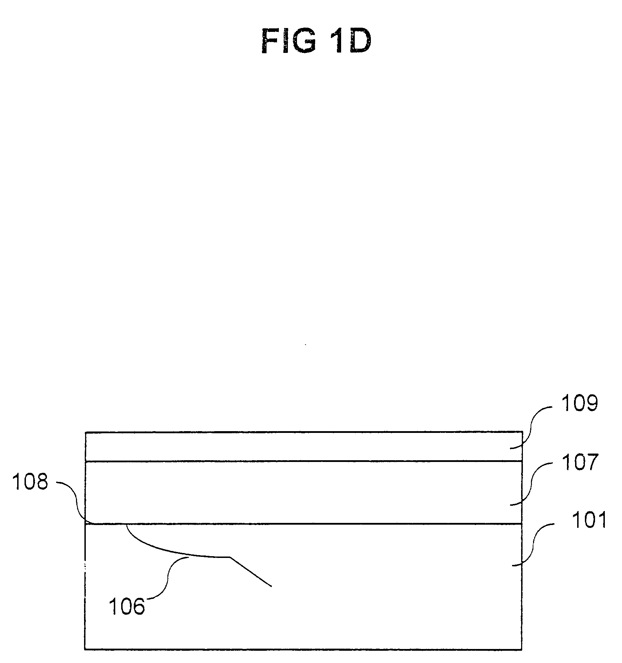

In einem weiteren Schritt (vgl. **Fig.1d**) wird eine zweite Streuoxidschicht 109 auf die Metallschicht 107 aufgebracht.

Es ist in diesem Zusammenhang anzumerken, dass im Rahmen der Erfindung das Vorsehen von Streuoxidschichten oder Streunitridschichten nicht unbedingt erforderlich ist.

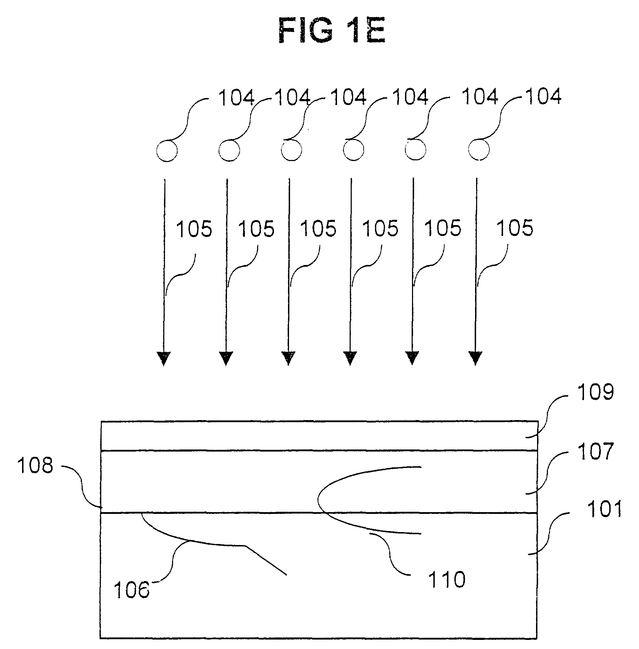

In einem weiteren Schritt (vgl. **Fig.1e**) wird die resultierende Struktur einer weiteren Stickstoffatom-Implantation, d.h. einer weiteren Implantation von Stickstoffatomen 104, symbolisiert durch Pfeile 105 in **Fig.1e,** unterzogen derart, dass sich ein zweites Dotierungsprofil 110, wie in **Fig.1e** dargestellt, ergibt. Das sich somit ergebende zweite Dotierungsprofil 110 zeigt, dass die Stickstoffatome 104 bei der zweiten Implantierung sowohl in der Metallschicht 107 als auch in der Substratschicht 101 enthalten sind.

In einem weiteren Schritt wird die zweite Streuoxidschicht 109 mittels eines Trockenätzverfahrens, eines Nassätzverfahrens oder mittels eines CMP-Verfahrens entfernt.

Die somit gebildete mit Stickstoffatomen 104 dotierte Einheit von Substratschicht 101 und Metallschicht 107 wird einem Kurzzeittemper-Verfahren bei einer Temperatur von ungefähr 1000 □C unterzogen.

Durch das Tempern bildet sich eine Barriereschicht 111 zwischen der Substratschicht 101 und der Metallschicht 107 aus.

Dies erfolgt, indem die implantierten Stickstoffatome 104 mit dem Wolfram der Metallschicht 107 und dem Silizium bzw. Polysilizium der Substratschicht 101 reagieren, so dass sich eine Barriereschicht 111 einer Legierung WSiN ergibt.

Insgesamt ergibt sich somit für das elektronische Bauelement, beispielsweise eine Gate-Struktur eines MOS-Feldeffekttransistors eine Struktur von Silizium oder Polysilizium / der Metalllegierung Wolfram-Silizium-Stickstoff / und dem Metall Wolfram.

Die sich auf diese Weise ergebende Struktur kann beispielsweise als Gate-Elektrode eines MOS-Feldeffekttransistors oder auch als elektrischer Anschluss einer Source, einer Drain oder eines Substrats in einem MOS-Feldeffekttransistor eingesetzt werden.

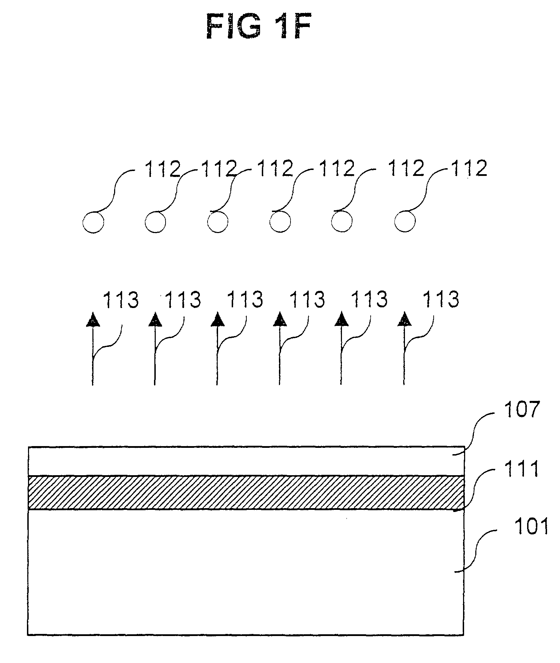

Die im Rahmen des Temperns und des Bildens der Barriereschicht 111 nicht reagierenden Stickstoffatome 112 entweichen aus der Struktur, in **Fig.1f** symbolisiert durch Pfeile 113.

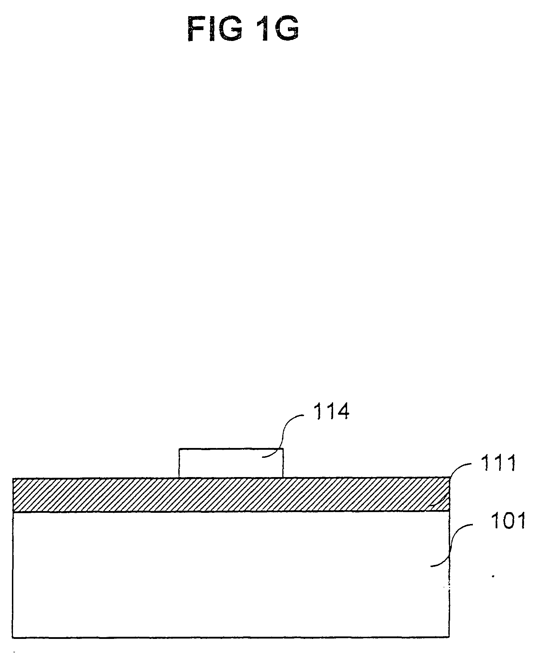

**Fig.1g** zeigt die dotierte Metallschicht 114, wie sie nach einer vorgegebenen Maskierung und Strukturierung entsteht.

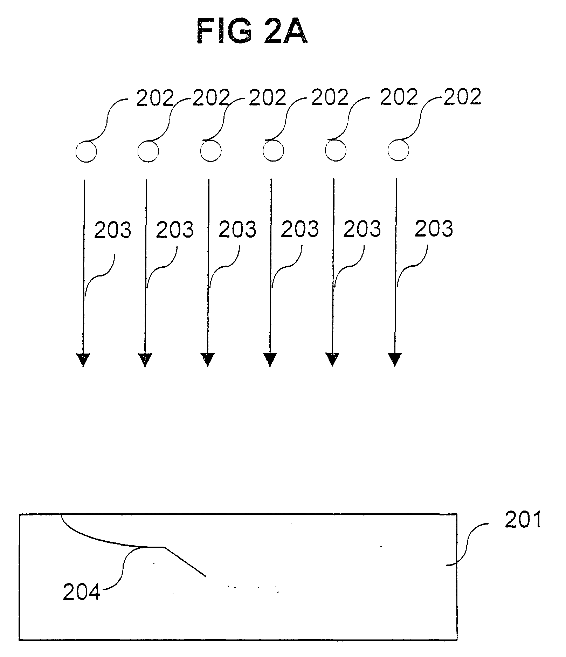

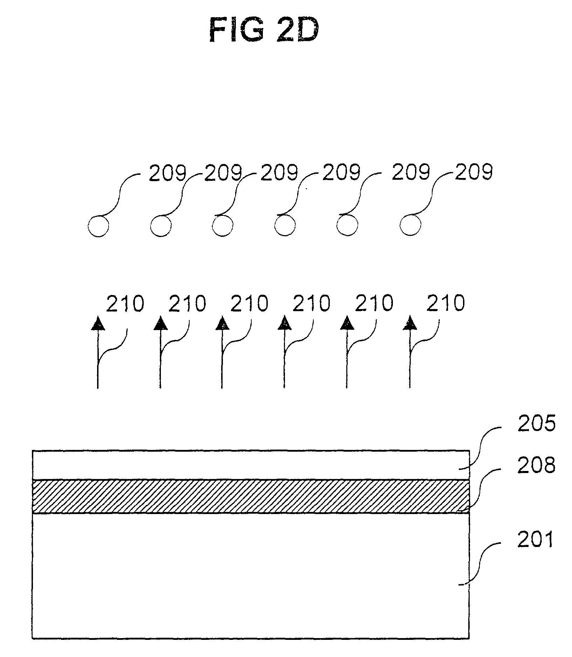

Ein zweites Ausführungsbeispiel der Erfindung ist in den **Fig.2a** bis **Fig.2e** dargestellt.

Gemäß dem zweiten Ausführungsbeispiel wird von einer Siliziumschicht als Substratschicht 201 ausgegangen, in die unmittelbar, ohne Vorsehen einer Streuoxidschicht gemäß dem ersten Ausführungsbeispiel, Stickstoffatome 202 implantiert werden, in **Fig.2a** symbolisiert durch Pfeile 203.

Es ergibt sich somit ein Dotierungsprofil 204 in der Substratschicht 201.

In diesem Fall erfolgt das Implantieren bei einer Implantationsspannung von ungefähr 10 keV. Die Implantationsspannung wird gemäß dem zweiten Ausführungsbeispiel geringer gewählt, da keine Streuoxidschicht oder Metallschicht von den Stickstoffatomen durchdrungen werden muss, um zu der Substratschicht 201 zu gelangen.

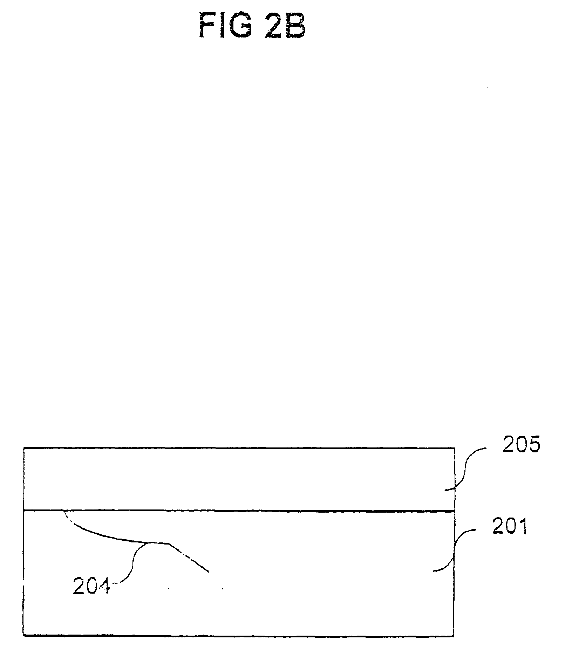

Auf der Substratschicht 201 wird mittels eines CVD-Verfahrens eine Metallschicht 205 abgeschieden (vgl. **Fig.2b).**

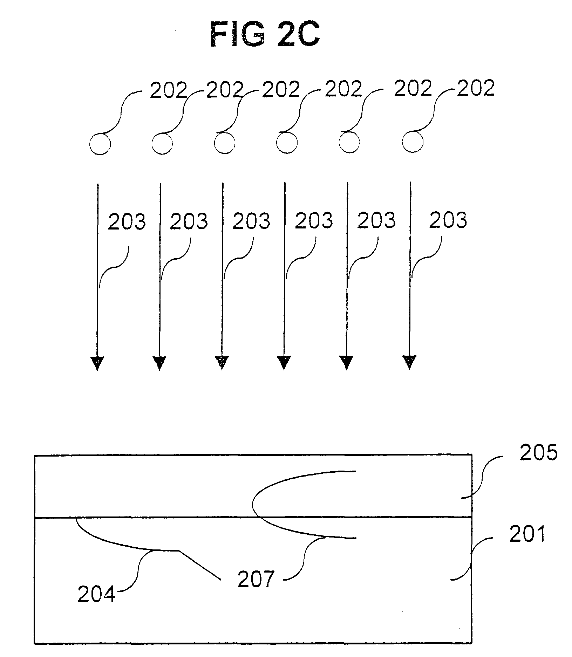

Wie in **Fig.2c** dargestellt ist, erfolgt anschließend eine zweite Implantation von Stickstoffatomen 202 in die Metallschicht 205 und die Siliziumschicht 201.

Dies ist in **Fig.2c** wiederum durch Pfeile 203 symbolisiert.

Es ergibt sich somit ein zweites Implantationsprofil 207, das zeigt, dass die Implantationsatome, d.h. gemäß dem zweiten Ausführungsbeispiel die Stickstoffatome 202 sowohl in der Metallschicht 205 als auch in der Substratschicht 201 enthalten sind.

Wie auch gemäß dem ersten Ausführungsbeispiel erfolgt auf die resultierende Struktur das Durchführen eines Kurzzeittemper-Verfahrens, wodurch die Barriereschicht 208 gebildet wird, und wobei nicht reagierende Stickstoffatome 209 entweichen, symbolisiert durch Pfeile 210.

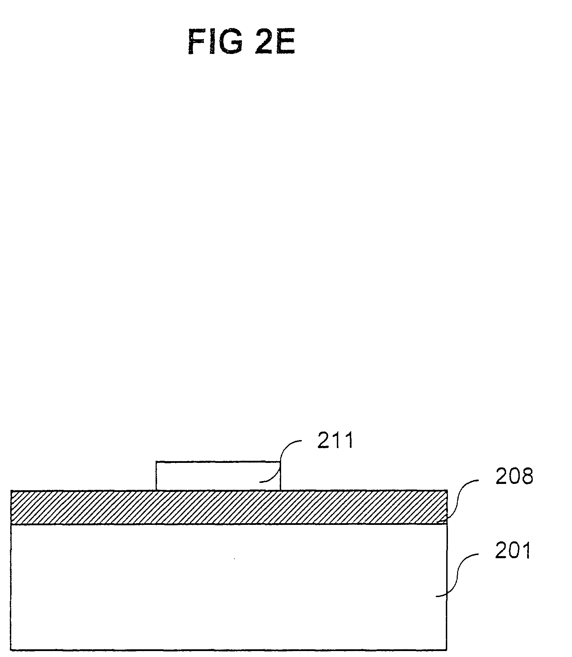

**Fig.2e** zeigt die strukturierte Metallschicht 211 in der sich ergebenden Struktur gemäß dem zweiten Ausführungsbeispiel.

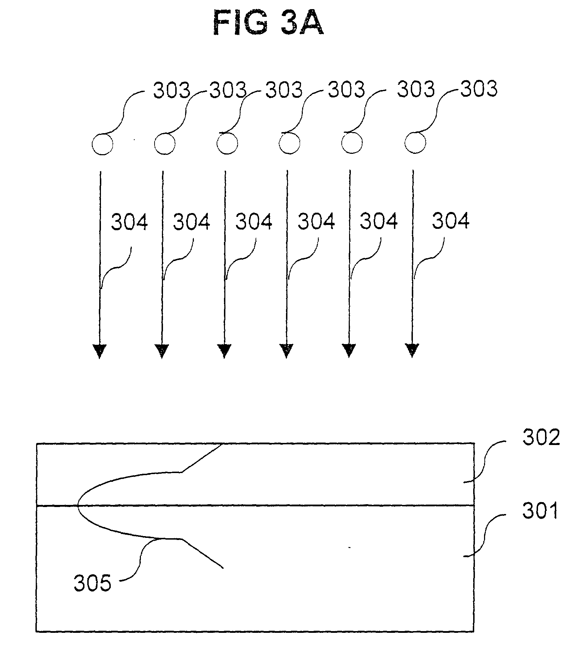

**Fig.3a** bis **Fig.3c** zeigen verschiedene Verfahrenszustände eines Herstellungsverfahrens eines elektronischen Bauelements bzw. der Barriereschicht eines elektronischen Bauelements gemäß einem dritten Ausführungsbeispiel.

Ausgegangen wird gemäß diesem dritten Ausführungsbeispiel von einer Siliziumschicht oder Polysiliziumschicht als Substratschicht 301 und einer darauf beispielsweise mittels eines CVD-Verfahrens aufgebrachten Metallschicht 302.

Gemäß dem dritten Ausführungsbeispiel werden Boratome 303 als Implantationsatome in die Metallschicht 302 sowie die Substratschicht 301 implantiert, symbolisiert in **Fig.3a** durch Pfeile 304.

Es ergibt sich somit in der Metallschicht 302 und der Substratschicht 301 ein Dotierungsprofil 305, mit dem angezeigt wird, dass sich die implantierten Boratome 303 sowohl in der Metallschicht 302 als auch in der Substratschicht 301 befinden.

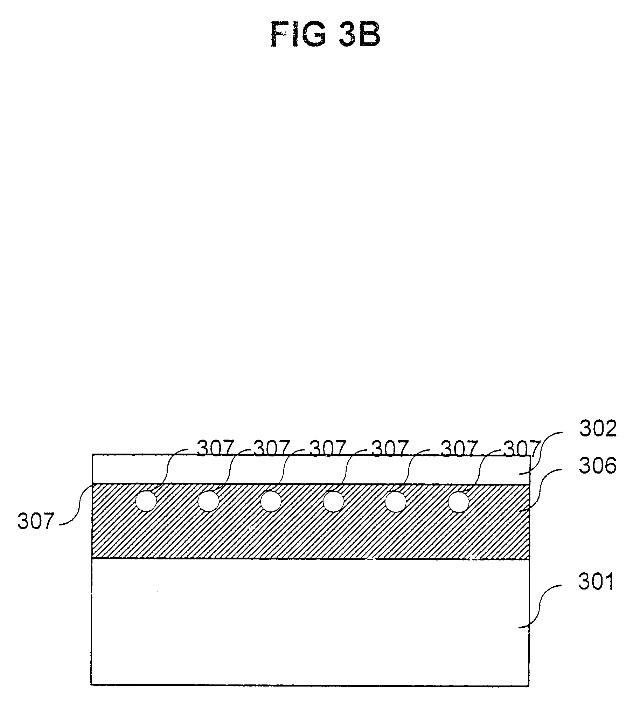

Die sich auf diese Weise ergebende Struktur wird in einem weiteren Verfahrensschritt einer Temperung, gemäß dem dritten Ausführungsbeispiel einem Kurzzeittemper-Verfahren bei einer Temperatur von ungefähr 1000 □C unterzogen, wodurch eine Barriereschicht 306 gebildet wird, grundsätzlich gemäß dem Verfahren, wie es im Zusammenhang mit dem ersten Ausführungsbeispiel beschrieben worden ist (vgl. **Fig.3b**).

Es ergibt sich somit eine Barriereschicht 306 aus einer Legierung aus Silizium/Bor/Wolfram.

**Fig.3b** zeigt ferner, dass während des Bildens der Barriereschicht 306 an der Grenzfläche 308 der Barriereschicht 306 diese mit nicht reagierenden Boratomen 307 angereichert wird, weshalb in einem Grenzbereich in der Nähe der Grenzfläche 308 eine mit Bor angereicherte Silizium/Bor/Wolfram-Schicht gebildet wird.

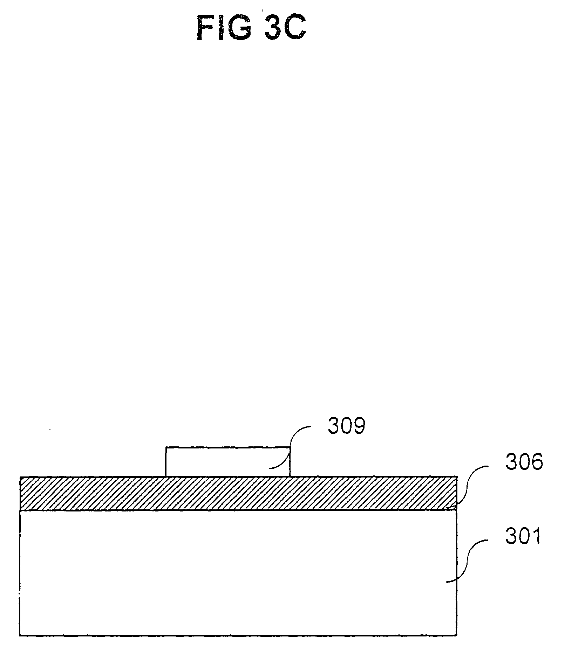

**Fig.3c** zeigt ferner die strukturierte Metallschicht 309, wie sie durch entsprechende Photolithographie-Technik gebildet werden kann.

In diesem Dokument sind folgende Veröffentlichungen zitiert:
[1] Byung Hak Lee et al., In-situ Barrier Formation for High Reliable W/barrier/poly-Si Gate Using Denudation of WNₓ on Polycrystalline Si, IEDM, Technical Digest, San Francisco 1998.
[2] Wein-Town Sun et al, Mechanism of Improved Thermal Stability of Cobalt Silicide Formed on Polysilicon Gate by Nitrogen Implantation, Jpn. J. Appl. Phys., Vol. 37, Part I, No. 11, S. 5854 - 5860, November 1998.
[3] M. Delfino et al, Formation of TiN/TiSi₂/p⁺-Si/n-Si by Rapid Thermal Annealing (RTA) Silicon Implanted with Boron through Titanium, IEEE Electron Device Letters, Vol. EDL-6, No. 11, S. 591 - 593, November 1985.
[4] Eiji Nagasawa et al, Mo- and Ti-Silicided Low-Resistance Shallow Junctions Formed Using the Ion Implantation Through Metal Technique, IEEE Transactions on Electron Devices, Vol. ED-34, No. 3, S. 581 - 586, March 1987.
[5] US 5,648,287.

## Patentansprüche

1. Verfahren zum Herstellen einer Barriereschicht in einem elektronischen Bauelement,
• bei dem Implantierungsatome, die zum Bilden der Barriereschicht dienen, in ein Substratmaterial implantiert werden,
• bei dem auf das Substratmaterial eine Metallschicht aufgebracht wird,
• bei dem das Substratmaterial, die Implantierungsatome und die Metallschicht zumindest teilweise miteinander in Reaktion gebracht werden derart, dass die Barriereschicht gebildet wird, wobei durch die Barriereschicht eine Silizidierung der Metallschicht durch die Barriereschicht hindurch verhindert wird.

2. Verfahren nach Anspruch 1,
bei dem als die Implantierungsatome Stickstoffatome oder Boratome verwendet werden.

3. Verfahren nach Anspruch 1 oder 2,
bei dem das Substratmaterial Silizium oder Gallium-Arsenid oder Germanium enthält.

4. Verfahren nach einem der vorangegangenen Ansprüche,
bei dem das Substratmaterial, die Implantierungsatome und die Metallschicht zumindest teilweise miteinander in Reaktion gebracht werden, indem eine Temperung des Substratmaterials, der Implantierungsatome und der Metallschicht durchgeführt wird.

5. Verfahren nach einem der vorangegangenen Ansprüche,
bei dem das Implantieren der Implantierungssatome erfolgt, nachdem die Metallschicht auf das Substratmaterial aufgebracht worden ist.

6. Verfahren nach einem der vorangegangenen Ansprüche,
• bei dem auf das Substratmaterial oder auf die Metallschicht eine Streuoxidschicht aufgebracht wird, und
• bei dem das Implantieren der Implantierungsatome durch die Streuoxidschicht hindurch erfolgt.

7. Verfahren nach einem der vorangegangenen Ansprüche,
bei dem die Streuoxidschicht Siliziumoxid enthält.

8. Verfahren nach einem der vorangegangenen Ansprüche,
bei dem die Metallschicht zumindest eines der folgenden Metalle enthält:
• Wolfram,
• Mobdylän,
• Tantal,
• Rhenium,
• Titan,
• Zirkon,
• Hafnium,
• Niob, und/oder
• Ruthenium.

9. Verfahren zum Herstellen eines elektronischen Bauelements mit einer Barriereschicht,
• bei dem das elektronische Bauelement hergestellt wird, und
• bei dem die Barriereschicht gemäß einem Verfahren nach einem der Ansprüche 1 bis 8 hergestellt wird.

10. Verfahren nach Anspruch 9,
• bei dem als elektronisches Bauelement ein Transistor hergestellt wird, und
• bei dem aus der Metallschicht ein Gate des Transistors gebildet wird.

11. Verfahren nach einem der Ansprüche 1 bis 9,
bei dem aus der Metallschicht ein elektrischer Kontakt in dem elektronischen Bauelement gebildet wird.
